# EUROPÄISCHE PATENTSCHRIFT

(11) **EP 0 820 638 B1**
(45) Veröffentlichungstag und Bekanntmachung des Hinweises auf die Patenterteilung: **31.10.2001**
(21) Anmeldenummer: 96907307.1
(22) Anmeldetag: 29.03.1996
(51) Int. Cl.: H01L 21/28

(54) **VERFAHREN ZUM HERSTELLEN EINES ELEKTRISCHEN KONTAKTS AUF EINER SiC-OBERFLÄCHE**
PROCESS FOR PRODUCING AN ELECTRICAL CONTACT ON A SiC SURFACE
PROCEDE DE PRODUCTION D'UN CONTACT ELECTRIQUE SUR UNE SURFACE EN CARBURE DE SILICIUM (SiC)

(30) Priorität: 13.04.1995 DE 19514081
(43) Veröffentlichungstag der Anmeldung: 28.01.1998
(73) Patentinhaber: SiCED Electronics Development GmbH & Co KG, 91052 Erlangen (DE)
(72) Erfinder: RUPP, Roland, D-91207 Lauf (DE)
(74) Vertreter: Zedlitz, Peter, Dipl.-Inf.
(86) Internationale Anmeldenummer: DE9600555
(87) Internationale Veröffentlichungsnummer: WO9632739

(56) Entgegenhaltungen:
- GB-A- 1 112 016
- US-A- 5 352 636
- NOVEL REFRACTORY SEMICONDUCTORS SYMPOSIUM, ANAHEIM, CA, USA, 21-23 APRIL 1987, ISBN 0-931837-64-2, 1987, PITTSBURGH, PA, USA, MATER. RES. SOC, USA, Seiten 265-270, XP000579589 BELLINA J J JR ET AL: "Thermally activated reactions of titanium thin films with (100) 3C-SiC substrates"
- JOURNAL OF APPLIED PHYSICS, 15 OCT. 1986, USA, Bd. 60, Nr. 8, ISSN 0021-8979, Seiten 2842-2853, XP000570880 MUEHLHOFF L ET AL: "Comparative electron spectroscopic studies of surface segregation on SiC(0001) and SiC(0001)" in der Anmeldung erwähnt
- PROCEEDINGS OF THE 32ND NATIONAL SYMPOSIUM OF THE AMERICAN VACUUM SOCIETY, HOUSTON, TX, USA, 19-22 NOV. 1985, Bd. 4, Nr. 3, pt.2, ISSN 0734-2101, JOURNAL OF VACUUM SCIENCE & TECHNOLOGY A (VACUUM, SURFACES, AND FILMS), MAY-JUNE 1986, USA, Seiten 1692-1695, XP002011767 BELLINA J J JR ET AL: "Surface modification strategies for (100)3C-SiC"
- PROCEEDINGS OF THE SEVENTH SYMPOSIUM ON APPLIED SURFACE ANALYSIS, COLLEGE PARK, MD, USA, 15-17 MAY 1985, Bd. 25, Nr. 4, ISSN 0169-4332, APPLIED SURFACE SCIENCE, MAY 1986, NETHERLANDS, Seiten 380-390, XP000600366 BELLINA J J JR ET AL: "Stoichiometric changes in the surface of (100) cubic SiC caused by ion bombardment and annealing"

## Beschreibung

Die Erfindung betrifft ein Verfahren zum Herstellen eines elektrischen Kontakts auf einer Siliciumcarbid-Oberfläche.

Elektrische Kontakte auf Siliciumcarbid (SiC) werden im allgemeinen durch Aufbringen eines Metalls wie beispielsweise Platin, Wolfram, Titan, Nickel oder Chrom direkt auf eine SiC-Oberfläche hergestellt. Es sind sowohl ohmsche Kontakte als auch Schottky-Kontakte auf SiC bekannt.

Aus *Appl. Phys. Lett., Vol. 65, No. 16, 17. October 1994, Seiten 2075-2077* ist ein Verfahren zum Herstellen eines ohmschen Kontakts auf n-leitendem, kubischem β-SiC bekannt, bei dem eine 150 nm dicke Schicht aus Titancarbid (TiC) chemisch aus der Gasphase (Chemical Vapour Deposition = CVD) auf einer (111)-Oberfläche des β-SiC epitaktisch abgeschieden wird. Die verwendeten Prozeßgase für diesen CVD-Prozeß sind TiCl₄ und C₂H₄.

Ein Problem bei diesen bekannten Herstellungsverfahren zum Herstellen eines elektrischen Kontakts auf einer SiC-Oberfläche stellt die natürliche Oxidbelegung jeder freien SiC-Oberfläche in einer Sauerstoffatmosphäre dar. Bei ohmschen Kontakten wird durch diese natürliche Oxidschicht der Kontaktwiderstand erhöht. Bei Schottky-Kontakten führt die Oxidschicht zu einer Erniedrigung der Kontaktbarriere und damit zu höheren Leckströmen bei Anlegen einer Sperrspannung. Die natürliche Oxidschicht muß deshalb im allgemeinen vor dem Aufbringen des Metalls oder des TiC durch Sputtern oder mit Flußsäure (HF) entfernt werden.

Aus der Veröffentlichung Novel Refractory Semiconductors Symposium, Anaheim (US), 21. - 23.4.87 - Proceedings p 265 bis 270 ist eine Methode zum Herstellen eines elektrischen Kontakts auf einer SiC-Oberfläche bekannt, bei dem an einer Siliciumcarbid-Oberfläche eine Kohlenstoffschicht durch Abdampfen von Silizium-Atomen erzeugt wird, diese Schicht mit Argon-Ionen zur Entfernung von Siliciumoxiden behandelt wird und anschließend die Kohlenstoffschicht mit Titan als carbidbildendem Material zu Titancarbid umgewandelt wird. Dieses Verfahrens ist durch das Argon-Sputtern vergleichsweise aufwendig, da ein separater Vakuumprozeßschritt notwendig ist.

Aufgabe der Erfindung ist nun, ein besonderes Verfahren zum Herstellen eines elektrischen Kontakts auf einer SiC-Oberfläche anzugeben.

Diese Aufgabe wird gemäß der Erfindung gelöst mit den Merkmalen des Anspruchs 1. In einem ersten Verfahrensschritt wird an der SiC-Oberfläche eine Kohlenstoffschicht erzeugt. In einem anschließenden zweiten Verfahrensschritt wird die Kohlenstoffschicht mit wenigstens einem carbidbildenden Metall zumindest weitgehend in das entsprechende Metallcarbid umgewandelt. Die Dicke der Kohlenstoffschicht wird kleiner als 1 nm eingestellt. Die Kohlenstoffschicht umfaßt dann nur wenige Atomlagen oder sogar nur eine Atomlage von Kohlenstoffatomen.

Besonders vorteilhaft ist dabei, wenn vor dem Erzeugen der Kohlenstoffschicht die Siliciumcarbid-Oberfläche einer Wasserstoffatmosphäre bei Temperaturen von wengistens 500°C ausgesetzt wird. Mit einem solchen Vorgehen läßt sich verhindern, daß auf der Siliciumcarbid-Oberfläche, die vorzugsweise durch epitaktisches Wachstum erzeugt wurde, Oxide entstehen. Ein separater Vakuumprozeßschritt ist dazu nicht erforderlich, so daß das gesamte Verfahren wesentlich vereinfacht wird.

Vom Stand der Technik, beispielsweise der US-A-5 352 636 ist es zwar bekannt, einen Siliciumwafer in Wasserstoff bei 800 bis 950° von Oxid zu reinigen. Weiterhin zeigt die GB-A-1 112 016, daß Siliciumcarbid mit einer Wasserstoffatmosphäre verträglich ist.

Der Erfindung liegt die Überlegung zugrunde, daß sich auf der Kohlenstoffschicht im Gegensatz zu einer freien SiC-Oberfläche keine die Kontakteigenschaften verschlechternde Oxidschicht bildet. Durch die chemische Reaktion des Kohlenstoffs (C) mit dem Metall wird eine nahezu sauerstofffreie Metallcarbid-Siliciumcarbid-Grenzfläche für den elektrischen Kontakt erzeugt.

Vorteilhafte Ausgestaltungen und Weiterbildungen des Verfahrens gemäß der Erfindung ergeben sich aus den vom Anspruch 1 abhängigen Ansprüchen.

Das Verfahren ist besonders vorteilhaft zum Herstellen eines elektrischen Kontakts auf einer Oberfläche eines SiC-Einkristalls, insbesondere vom kubischen Polytyp (β-SiC) oder von einem nicht kubischen Polytyp (α-SiC). Als SiC-Oberfläche wird dabei vorzugsweise die Siliciumseite oder die Kohlenstoffseite des SiC-Einkristalls (basal planes) verwendet. Die Siliciumseite entspricht beim α-SiC einer (0 0 0 1)-Kristallfläche und beim β-SiC einer (1 1 1)-Kristallfläche. Die Kohlenstoffseite entspricht dagegen beim α-SiC einer (0 0 0 -1)-Kristallfläche und beim β-SiC einer (-1 -1 -1)-Kristallfläche. Der SiC-Einkristall wird vorzugsweise durch chemische Dampfabscheidung (CVD) auf einem Substrat hergestellt, kann aber auch durch Molekularstrahlepitaxie (Molecular Beam Epitaxy = MBE) oder einen Sublimationsprozeß hergestellt sein. Eine besondere Variante zur Herstellung des SiC-Einkristalls ist die Atomlagenepitaxie (Atomic Layer Epitaxy = ALE), bei der in aufeinanderfolgenden CVD- oder MBE-Prozeßschritten abwechselnd Siliciumatomlagen und Kohlenstoffatomlagen erzeugt werden zum Aufbau des SiC-Kristallgitters.

Die Kohlenstoffschicht wird in einer besonders vorteilhaften Ausführungsform durch Abdampfen von Siliciumatomen von der SiC-Oberfläche und/oder dem darunterliegenden SiC erzeugt. Vorzugsweise wird die SiC-Oberfläche dazu in einem Vakuum oder in einer Inertgasatmosphäre auf eine Temperatur von wenigstens etwa 1000° C gebracht. Die Kohlenstoffschicht kann aber auch durch chemische Dampfabscheidung (CVD) oder Molekularstrahlepitaxie (MBE) erzeugt werden. Vorzugsweise wird eine Kohlenstoffschicht mit einer zumindest graphitähnlichen Kristallstruktur erzeugt.

Das carbidbildende Metall kann insbesondere durch einen Sputterprozeß oder einen Verdampfungsprozeß zur Kohlenstoffschicht gebracht werden. Beim Sputtern wird in einer bevorzugten Ausführungsform die kinetische Energie der beschleunigten Metallionen oder Metallatome mindestens so groß eingestellt wie die zur Bildung des Metallcarbids erforderliche Energie. Das Metallcarbid bildet sich dann bereits beim Auftreffen der Metallteilchen. Es können aber auch zunächst das carbidbildende Metall als Metallschicht auf die Kohlenstoffschicht aufgebracht werden, beispielsweise durch Aufdampfen oder Sputtern mit niedrigeren kinetischen Energien als der Bildungsenergie des Metallcarbids, und dann das Metall mit dem Kohlenstoff durch eine Wärmebehandlung chemisch reagiert werden. Als carbidbildende Metalle können beispielsweise Wolfram (W), Titan (Ti), Tantal (Ta), Bor (B), Aluminium (Al), Nickel (Ni) oder Scandium (Sc) verwendet werden.

In einer weiteren Ausführungsform wird die SiC-Oberfläche vor dem Erzeugen der Kohlenstoffschicht bei Temperaturen von wenigstens 500°C einer Wasserstoffatmosphäre ausgesetzt. Man erhält so eine SiC-Oberfläche, die im wesentlichen frei von Sauerstoff ist.

Zur weiteren Erläuterung der Erfindung wird auf die Zeichnung Bezug genommen, in deren
- FIG 1 und 2: ein erster Ausführungsweg zum Erzeugen einer Kohlenstoffschicht auf einer SiC-Oberfläche
- FIG 3 und 4: ein zweiter Ausführungsweg zum Erzeugen einer Kohlenstoffschicht auf einer SiC-Oberfläche
- FIG 5 bis 7: zwei Ausführungswege zum Umwandeln der Kohlenstoffschicht in eine Metallcarbidschicht auf der SiC-Oberfläche als elektrischer Kontakt
schematisch dargestellt sind. Einander entsprechende Teile sind mit denselben Bezugszeichen versehen.

In allen dargestellten Ausführungsformen sind ein SiC-Einkristall mit 2 und eine SiC-Oberfläche dieses SiC-Einkristalls 2 mit 3 bezeichnet.

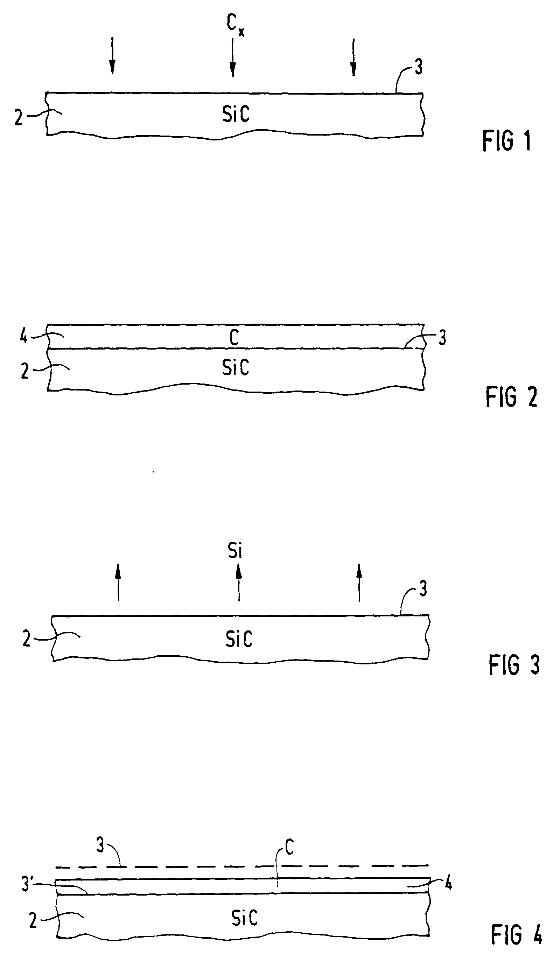

Gemäß FIG. 1 wird der SiC-Oberfläche 3 Kohlenstoff Cₓ in elementarer Form C, beispielsweise durch Sputtern, oder in Form einer chemischen Kohlenstoffverbindung, beispielsweise durch CVD oder MBE, zugeführt.

Aus dem zugeführten Kohlenstoff Cₓ wird, wie in FIG. 2 dargestellt, auf der SiC-Oberfläche 3 eine Kohlenstoffschicht 4 abgeschieden. Bei einem CVD-Prozeß oder einem MBE-Prozeß wird im allgemeinen ein Kohlenwasserstoffgas wie beispielsweise C₂H₂ verwendet, aus dem sich bei geeignet eingestellten Prozeßbedingungen wie insbesondere Druck und Temperatur durch chemische Reaktionen im Bereich der SiC-Oberfläche 3 die Kohlenstoffschicht 4 bildet. Typische Prozeßtemperaturen liegen dabei zwischen 500°C und 1500°C.

In einer anderen, in FIG 3 dargestellten Ausführungsform werden dagegen im SiC-Kristallgitter gebundene Siliciumatome von der SiC-Oberfläche 3 entfernt, vorzugsweise abgedampft. Zum Abdampfen (Absublimieren) der Siliciumatome wird die SiC-Oberfläche 3 vorzugsweise einer Wärmebehandlung bei Temperaturen von wenigstens 1000°C unterzogen, vorzugsweise in einem Vakuum oder in einer Inertgasatmosphäre. Unter einem Inertgas wird dabei ein Gas verstanden, das bei den verwendeten Temperaturen chemisch mit SiC praktisch nicht reagiert, beispielsweise Argon (Ar). Da der Dampfdruck von Silicium (Si) im SiC höher ist als der Dampfdruck des Kohlenstoff (C), bleibt beim Abdampfen der Siliciumatome an der SiC-Oberfläche 3 ein Überschuß an Kohlenstoffatomen zurück.

Diese überschüssigen Kohlenstoffatome formieren sich zu einer Kohlenstoffschicht 4, die in FIG 4 gezeigt ist. Es ergibt sich eine neue, etwas zurückgewichene SiC-Oberfläche 3', die an die Kohlenstoffschicht 4 angrenzt. Die vorherige SiC-Oberfläche 3 vor dem Entfernen der Siliciumatome ist in FIG 4 gestrichelt eingezeichnet.

Sowohl durch Zuführen von Kohlenstoff gemäß den FIG 1 und 2 als auch durch Verdampfen von Silicium gemäß den FIG 3 und 4 wird also an der SiC-Oberfläche 3 bzw. 3' eine Kohlenstoffschicht 4 erzeugt. Die Kohlenstoffschicht 4 kann beispielsweise mit einer im wesentlichen amorphen Struktur und vorzugsweise miteinerGraphitstrukturoderzumindest graphitähnlichen Struktur hergestellt werden. In der erfindungsgemäßen Ausführungsform wird eine unter 1 nm dicke Kohlenstoffschicht 4 erzeugt.

In einer besonders vorteilhaften Ausgestaltung des Verfahrens wird als SiC-Oberfläche 3 eine der polaren Seiten (basal planes), also die Siliciumseite oder die Kohlenstoffseite, des SiC-Einkristalls 2 verwendet. Die Siliciumseite entspricht einer (1 1 1)-Kristallfläche im polaren Kristallgitter bei einem SiC-Einkristall 2 vom kubischen Polytyp 3C (β-SiC) und einer (0 0 0 1)-Kristallfläche im polaren Kristallgitter eines SiC-Einkristalls von einem nicht kubischen Polytyp wie beispielsweise 4H, 6H oder 15 R (α-SiC). Unter der Kohlenstoffseite versteht man dagegen eine (-1 -1 -1)-Kristallfläche im polaren Kristallgitter bei einem SiC-Einkristall 2 vom kubischen Polytyp 3C (β-SiC) und eine (0 0 0 -1)-Kristallfläche im polaren Kristallgitter eines SiC-Einkristalls von einem nicht kubischen Polytyp wie beispielsweise 4H, 6H oder 15 R (α-SiC).

In dieser Ausgestaltung des Verfahrens wird die Kohlenstoffschicht 4 vorzugsweise durch Abdampfen von Siliciumatomen von der SiC-Oberfläche 3 erzeugt. Die Siliciumseite oder die Kohlenstoffseite des SiC-Einkristalls 3 wird dazu einer bereits beschriebenen Wärmebehandlung unterzogen. Durch den zeitlichen Verlauf der Wärmebehandlung und die verwendeten Temperaturen kann sehr genau eingestellt werden, wie viele einzelne (1 1 1) bzw. (0 0 0 1)-Siliciumatomlagen aus dem SiC-Kristallgitter entfernt werden. Insbesondere kann auch nur die oberste Siliciumatomlage entfernt werden. Man erhält dann an der Siliciumseite eine Kohlenstoffschicht 4 aus nur einer Monolage von Kohlenstoffatomen und an der Kohlenstoffseite eine Kohlenstoffschicht 4 aus zwei Kohlenstoffatomlagen. Der an der Oberfläche zurückgebliebene Kohlenstoff rekonstruiert im allgemeinen durch Sättigen der offenen Bindungen zu einer Graphitstruktur (Graphitisierung). Das Abdampfen von Siliciumatomen von der Siliciumseite oder der Kohlenstoffseite eines SiC-Einkristalls bei verschiedenen Wärmebehandlungen und spektroskopische Untersuchungen der entstehenden Kohlenstoffschichten sind in dem Artikel *Muehlhoff et al* *"Comparative electron spectroscopic studies of surface segregation on SiC (0 0 0 1) und SiC (0 0 0 -1)", Journal of Applied Physics, Vol. 60, No. 8, 15 October 1986, Seiten 2842 bis 2853* beschrieben.

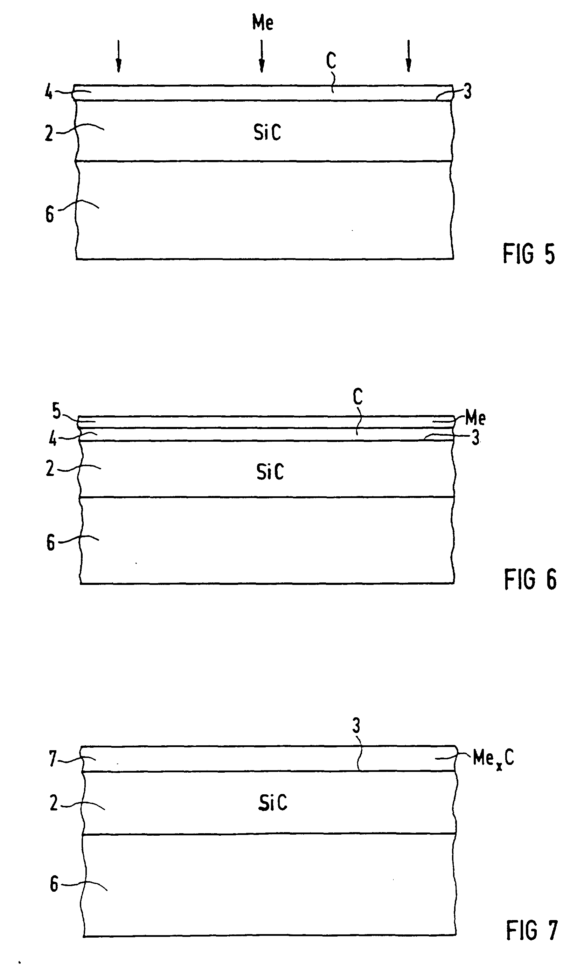

In den FIG 5 bis 7 sind zwei Ausführungswege zum Herstellen eines elektrischen Kontakts auf der SiC-Oberfläche 3 durch Umwandeln der an der SiC-Oberfläche 3 erzeugten Kohlenstoffschicht 4 in eine Metallcarbidschicht 7 veranschaulicht. Beide Ausführungswege gehen aus von einer Struktur mit einer an der SiC-Oberfläche 3 erzeugten Kohlenstoffschicht 4 gemäß einer der FIG 2, FIG 4 oder FIG 5. Der Kohlenstoffschicht 4 wird, wie in FIG 5 gezeigt ist, wenigstens ein carbidbildendes Metall, das mit Me bezeichnet ist, zugeführt. Vorzugsweise wird das Metall Me durch einen Sputterprozeß oder durch thermisches Aufdampfen zur Kohlenstoffschicht 4 gebracht.

Beim ersten Ausführungsweg wird die Energie der auf der Kohlenstoffschicht 4 auftreffenden Metallatome oder Metallionen kleiner als die chemische Bildungsenergie zum Bilden eines Metallcarbids MeₓC zwischen dem Metall Me und dem Kohlenstoff C der Kohlenstoffschicht 4 eingestellt. Es wird dann gemäß FIG 6 zunächst auf der Kohlenstoffschicht 4 eine separate Metallschicht 5 aus dem Metall Me abgeschieden. Diese Metallschicht 5 wird anschließend vorzugsweise durch eine Wärmebehandlung mit der Kohlenstoffschicht 4 chemisch in eine Metallcarbidschicht 7 umgewandelt. Die Temperatur und damit die thermische Energie bei der Wärmebehandlung wird dabei ausreichend groß gewählt, um die Bildung des Metallcarbids MeₓC zu ermöglichen.

Beim zweiten Ausführungsweg wird dagegen die Energie der auf der Kohlenstoffschicht 4 ankommenden Metallatome oder Metallionen wenigstens so groß wie die chemische Bildungsenergie des zugehörigen Metallcarbids MeₓC eingestellt, beispielsweise durch eine hinreichend große Beschleunigungsspannung beim Sputterprozeß. In diesem Fall bildet sich beim Aufbringen des wenigstens einen Metalls Me auf die Kohlenstoffschicht 4 direkt - ohne Bildung einer Metallschicht 5 wie beim ersten Ausführungsweg - eine Metallcarbidschicht 7 gemäß FIG 7.

Vorzugsweise wird das stöchiometrische Verhältnis von Metall Me zu Kohlenstoff C der Kohlenstoffschicht 4 so eingestellt, daß wenigstens annähernd der gesamte Kohlenstoff C der Kohlenstoffschicht 4 mit dem Metall Me zu Metallcarbid MeₓC reagiert. Es kann allerdings auch nur ein Teil des Kohlenstoffs C umgewandelt werden.

Als carbidbildende Metalle können beispielsweise Wolfram (W), Titan (Ti), Tantal (Ta), Bor (B), Aluminium (Al), Nickel (Ni) oder Scandium (Sc) verwendet werden. Die entsprechenden Metallcarbide MeₓC sind dann W₂C, TiC, TaC oder Ta₂C, B₄C, Al₄C₃, Ni₃C bzw. Sc₂C.

Vorzugsweise wird mit dem Verfahren gemäß der Erfindung ein Schottky-Kontakt hergestellt, der insbesondere für eine Schottky-Diode auf SiC-Basis verwendet wird. Die mit dem Verfahren hergestellte Siliciumcarbid-Metallcarbid-Grenzfläche weist eine nahezu ideale Kontaktbarriere und damit vergleichsweise geringe Leckströme auch bei hohen Sperrspannungen zwischen dem SiC-Einkristall 2 und der Metallcarbidschicht 7 auf.

Der SiC-Einkristall 2 ist in der in FIG 5 dargestellten Ausführungsform auf einem Substrat 6 in Form einer Schicht angeordnet und wird vorzugsweise in an sich bekannter Weise durch einen CVD-Prozeß oder einen MBE-Prozeß, insbesondere durch Atomlagenepitaxie, bei Temperaturen zwischen etwa 1000°C und etwa 1800°C oder auch durch Sublimationszüchtung bei Temperaturen von im allgemeinen zwischen etwa 2000°C und etwa 2300°C auf dem Substrat 6 aufgewachsen. Das Substrat 6 besteht vorzugsweise ebenfalls aus SiC. Es kann aber auch ein mit Hilfe eines Sublimationsprozesses gewachsener SiC-Einkristall 2 verwendet werden.

Wenn der SiC-Einkristall 2 durch CVD oder MBE hergestellt wird, kann die Kohlenstoffschicht 4 auf der SiC-Oberfläche 3 aufgewachsen werden, indem während des CVD-Prozesses bzw. des MBE-Prozesses die Siliciumzufuhr zum aufwachsenden SiC-Einkristall unterbrochen wird und nur noch Kohlenstoff zugeführt wird. Außerdem kann die Kohlenstoffschicht 4 auch erzeugt werden, indem der SiC-Einkristall 2 unmittelbar nach dem CVD-Prozeß oder dem MBE-Prozeß in Vakuum oder in einer Inertgasatmosphäre im allgemeinen bis auf Raumtemperatur gemäß einem vorgegebenen Temperaturverlauf abgekühlt wird.

Obgleich in den bisher beschriebenen Ausführungsformen des Verfahrens eine Oberfläche eines SiC-Einkristalls verwendet wurde, ist das Verfahren dennoch analog auch zum Herstellen von elektrischen Kontakten auf Oberflächen von nicht einkristallinen SiC-Körpern anwendbar, beispielsweise polykristallinen SiC-Körpern, die insbesondere durch Sintern hergestellt sein können.

## Patentansprüche

1. Verfahren zum Herstellen eines elektrischen Kontakts auf einer Siliciumcarbid-Oberfläche (3), bei dem
a) an dieser Siliciumcarbid-Oberfläche (3) eine Kohlenstoffschicht (4) erzeugt wird,
b) die Kohlenstoffschicht (4) anschließend mit wenigstens einem carbidbildenden Metall ganz oder teilweise in Metallcarbid umgewandelt wird,
**dadurch gekennzeichnet, daß**
c) die Kohlenstoffschicht (4) mit einer Dicke unter 1 nm erzeugt wird.

2. Verfahren nach Anspruch 1, **dadurch gekennzeichnet, daß** eine Oberfläche eines SiC-Einkristalls (2) als Siliciumcarbid-Oberfläche (3) verwendet wird.

3. Verfahren nach Anspruch 2, **dadurch gekennzeichnet, daß** der SiC-Einkristall (2) durch epitaktisches Abscheiden aus der Gasphase (CVD) auf einem Substrat (1) erzeugt wird.

4. Verfahren nach Anspruch 2, **dadurch gekennzeichnet, daß** die Siliciumcarbid-Oberfläche (3) mit einer Siliciumseite des SiC-Einkristalls (2) gebildet ist, die bei einem kubischen Polytyp des SiC (β-SiC) einer (1 1 1)-Kristallfläche und bei einem nicht kubischen Polytyp (α-SiC) einer (0 0 0 1)-Kristallfläche entspricht.

5. Verfahren nach Anspruch 2, **dadurch gekennzeichnet, daß** die Siliciumcarbid-Oberfläche (3) mit einer Kohlenstoffseite des SiC-Einkristalls (2) gebildet ist, die bei einem kubischen Polytyp des SiC (β-SiC) einer (-1 -1 -1)-Kristallfläche und bei einem nicht kubischen Polytyp (α-SiC) einer (0 0 0 -1)-Kristallfläche entspricht.

6. Verfahren nach einem der vorhergehenden Ansprüche, **dadurch gekennzeichnet, daß** die Kohlenstoffschicht (4) eine Graphitkristallstruktur aufweist.

7. Verfahren nach einem der vorhergehenden Ansprüche, **dadurch gekennzeichnet, daß** die Kohlenstoffschicht (4) durch Abdampfen von Siliciumatomen von der Siliciumcarbid-Oberfläche (3) erzeugt wird.

8. Verfahren nach Anspruch 7, **dadurch gekennzeichnet, daß** die Siliciumatome abgedampft werden, indem die Siliciumcarbid-Oberfläche (3) einem Vakuum oder einer Edelgasatmosphäre bei Temperaturen von wenigstens 1000° C ausgesetzt wird.

9. Verfahren nach einem der Ansprüche 1 bis 6, **dadurch gekennzeichnet, daß** die Kohlenstoffschicht (4) durch einen CVD-Prozeß erzeugt wird.

10. Verfahren nach einem der Ansprüche 1 bis 6, **dadurch gekennzeichnet, daß** die Kohlenstoffschicht (4) durch Molekularstrahlepitaxie erzeugt wird.

11. Verfahren nach einem der vorhergehenden Ansprüche,
**dadurch gekennzeichnet, daß** als carbidbildendes Metall ein Element aus der Wolfram (W), Titan (Ti), Tantal (Ta), Bor (B), Aluminium (Al), Nickel (Ni) und Scandium (Sc) umfassenden Gruppe verwendet wird.

12. Verfahren nach einem der vorhergehenden Ansprüche,
**dadurch gekennzeichnet, daß** das wenigstens eine carbidbildende Metall durch Sputtern zur Kohlenstoffschicht (4) gebracht wird.

13. Verfahren nach Anspruch 12, **dadurch gekennzeichnet, daß** die kinetische Energie der Metallatome oder Metallionen wenigstens so groß wie die chemische Bildungsenergie des zugehörigen Metallcarbids eingestellt wird.

14. Verfahren nach einem der vorhergehenden Ansprüche, **dadurch gekennzeichnet , daß** das carbidbildende Metall zunächst auf die Kohlenstoffschicht (4) aufgebracht wird und dann durch eine Temperaturbehandlung zur chemischen Reaktion mit dem Kohlenstoff gebracht wird.

15. Verfahren nach Anspruch 14, **dadurch gekennzeichnet, daß** das carbidbildende Metall auf die Siliciumcarbid-Oberfläche (3) aufgedampft wird.

16. Verfahren nach einem der vorhergehenden Ansprüche, **dadurch gekennzeichnet, daß** die Siliciumcarbid-Oberfläche (3) vor dem Erzeugen der Kohlenstoffschicht (4) einer Wasserstoffatmosphäre bei Temperaturen von wenigstens 500°C ausgesetzt wird.

## Claims

1. Method for producing an electrical contact on a silicon carbide surface (3), by which
a) a carbon coating (4) is produced on this silicon carbide surface (3),
b) the carbon coating (4) is subsequently converted, with at least one carbide-forming metal, completely or partly into metal carbide,
**characterized in that**
c) the carbon coating (4) is produced with a thickness of less than 1 nm.

2. Method according to claim 1, **characterized in that** a surface of a SiC single crystal (2) is used as the silicon carbide surface (3).

3. Method according to claim 2, **characterized in that** the SiC single crystal (2) is produced on a substrate (1) by epitaxial deposition from the vapour phase (CVD).

4. Method according to claim 2, **characterized in that** the silicon carbide surface (3) is formed with a silicon plane of the SiC single crystal (2) which in the case of a cubic polytype of the SiC (β-Sic) corresponds to a (1 1 1)-crystal face and in the case of a non cubic polytype (α-Sic) corresponds to a (0 0 0 1)-crystal face.

5. Method according to claim 2, **characterized in that** the silicon carbide surface (3) is formed with a carbon plane of the SiC single crystal (2) which in the case of a cubic polytype of the SiC (β-Sic) corresponds to a (-1 -1 -1)-crystal face and in the case of a non cubic polytype (α-Sic) corresponds to a (0 0 0 -1)-crystal face.

6. Method according to one of the preceding claims, **characterized in that** the carbon coating (4) has a graphite crystal structure.

7. Method according to one of the preceding claims, **characterized in that** the carbon coating (4) is produced by evaporating silicon atoms off from the silicon carbide surface (3).

8. Method according to claim 7, **characterized in that** the silicon atoms are evaporated by exposing the silicon carbide surface (3) to a vacuum or an inert gas atmosphere at temperatures of at least 1000°C.

9. Method according to one of claims 1 to 6, **characterized in that** the carbon coating (4) is produced by a CVD process.

10. Method according to one of claims 1 to 6, **characterized in that** the carbon coating (4) is produced by molecular beam epitaxy.

11. Method according to one of the preceding claims, **characterized in that** an element from the group that includes tungsten (W), titanium (Ti), tantalum (Ta), boron (B), aluminium (Al), nickel (Ni) and scandium (Sc) is used as the carbide-forming metal.

12. Method according to one of the preceding claims, **characterized in that** the at least one carbide-forming metal is brought to the carbon coating (4) by sputtering.

13. Method according to claim 12, **characterized in that** the kinetic energy of the metal atoms or metal ions is set so as to be at least as great as the chemical formation energy of the associated metal carbide.

14. Method according to one of the preceding claims, **characterized in that** the carbide-forming metal is first applied to the carbon coating (4) and then caused to react chemically with the carbon by means of heat treatment.

15. Method according to claim 14, **characterized in that** the carbide-forming metal is vapour-deposited onto the silicon carbide surface (3).

16. Method according to one of the preceding claims, **characterized in that** the silicon carbide surface (3) is exposed to a hydrogen atmosphere at temperatures of at least 500°C before the carbon coating (4) is produced.

## Revendications

1. Procédé de fabrication d'un contact électrique sur une surface de carbure de silicium (3), dans lequel
a) on produit sur cette surface de carbure de silicium (3) une couche de carbone (4),
b) puis, avec au moins un métal formant un carbure, on convertit en totalité ou en partie la couche de carbone (4) en un carbure métallique,
**caractérisé en ce que**
c) la couche de carbone (4) est produite en une épaisseur inférieure à 1 nm.

2. Procédé selon la revendication 1, **caractérisé en ce qu'**on utilise en tant que surface de carbure de silicium (3) une surface d'un monocristal de SiC (2).

3. Procédé selon la revendication 2, **caractérisé en ce que** le monocristal de SiC (2) est produit par dépôt par épitaxie en phase gazeuse (CVD) sur un substrat (1).

4. Procédé selon la revendication 2, **caractérisé en ce que** la surface de carbure de silicium (3) est formée avec une face silicium du monocristal de SiC (2), qui dans le cas d'un polytype cubique du SiC (β-SiC) correspond à une surface cristalline (1 1 1) et qui, dans le cas d'un polytype non-cubique (α-SiC) correspond à une surface cristalline (0 0 0 1).

5. Procédé selon la revendication 2, **caractérisé en ce que** la surface de carbure de silicium (3) est formée avec une face carbone du monocristal de SiC (2), qui dans le cas d'un polytype cubique du SiC (β-SiC) correspond à une surface cristalline (-1 -1 -1) et, dans le cas d'un polytype non-cubique (α-SiC), à une surface cristalline (0 0 0 -1).

6. Procédé selon l'une des revendications précédentes, **caractérisé en ce que** la couche de carbone (4) a une structure cristalline graphitique.

7. Procédé selon l'une des revendications précédentes, **caractérisé en ce que** la couche de carbone (4) est préparée par évaporation d'atomes de silicium à partir de la surface de carbure de silicium (3).

8. Procédé selon la revendication 7, **caractérisé en ce qu'**on provoque l'évaporation des atomes de silicium en exposant la surface de carbure de silicium (3) à un vide ou à une atmosphère d'un gaz rare à des températures d'au moins 1000°C.

9. Procédé selon l'une des revendications 1 à 6, **caractérisé en ce que** la couche de carbone (4) est produite par un procédé CVD.

10. Procédé selon l'une des revendications 1 à 6, **caractérisé en ce que** la couche de carbone (4) est produite par épitaxie par jets moléculaires.

11. Procédé selon l'une des revendications précédentes, **caractérisé en ce qu'**on utilise en tant que métal formant un carbure un élément choisi dans l'ensemble comprenant le tungstène (W), le titane (Ti), le tantale (Ta), le bore (B), l'aluminium (AI), le nickel (Ni) et le scandium (Sc).

12. Procédé selon l'une des revendications précédentes, **caractérisé en ce que** le ou les métaux formant un carbure sont amenés par pulvérisation cathodique à la couche de carbone (4).

13. Procédé selon la revendication 12, **caractérisé en ce que** l'énergie cinétique des atomes métalliques ou des ions métalliques est ajustée à une valeur au moins aussi grande que celle de l'énergie chimique de formation du carbure métallique correspondant.

14. Procédé selon l'une des revendications précédentes, **caractérisé en ce que** le métal formant un carbure est d'abord appliqué sur la couche de carbone (4), puis est amené au carbone par un traitement thermique pour subir une réaction chimique.

15. Procédé selon la revendication 14, **caractérisé en ce que** le métal formant un carbure est appliqué par métallisation sur la surface de carbure de silicium (3).

16. Procédé selon l'une des revendications précédentes, **caractérisé en ce que** la surface de carbure de silicium (3) est, avant production de la couche de carbone (4), exposée à une atmosphère d'hydrogène à des températures d'au moins 500°C.
